# EUROPÄISCHE PATENTSCHRIFT

(11) **EP 0 743 750 B1**
(45) Veröffentlichungstag und Bekanntmachung des Hinweises auf die Patenterteilung: **24.10.2001**
(21) Anmeldenummer: 96105672.8
(22) Anmeldetag: 11.04.1996
(51) Int. Cl.: H03K 17/00, H03K 17/94

(54) **Elektronisches, vorzugsweise berührungslos arbeitendes Schaltgerät**
Electronic switching device, preferably with contactless operation
Dispositif électronique de commutation, de préférence avec opération sans contact

(30) Priorität: 18.05.1995 DE 19517936
(43) Veröffentlichungstag der Anmeldung: 20.11.1996
(73) Patentinhaber: i f m electronic gmbh, 88069 Tettnang (DE)
(72) Erfinder: Lamarche, Jean-Luc, 67206 Mittelhausbergen (FR); Rundel, Guntram, 88255 Baienfurt (DE)
(74) Vertreter: Patentanwälte Gesthuysen, von Rohr, Weidener, Häckel

(56) Entgegenhaltungen:
- DE-A- 3 427 498
- DE-A- 4 041 823
- DE-A- 4 310 910
- US-A- 4 745 300

## Beschreibung

Die Erfindung betrifft ein elektronisches, vorzugsweise berührungslos arbeitendes Schaltgerät, insbesondere einen induktiven, kapazitiven oder optoelektronischen Näherungsschalter oder einen Strömungswächter, das über einen Außenleiter mit einem Pol einer Spannungsquelle und nur über einen weiteren Außenleiter mit einem Anschluß eines Verbrauchers verbindbar ist, wobei der andere Anschluß des Verbrauchers an den anderen Pol der Spannungsquelle anschließbar ist, mit einem von außen beeinflußbaren Anwesenheitsindikator, z. B. einem Oszillator, mit einem von dem Anwesenheitsindikator - ggf. über einen Schaltverstärker - steuerbaren elektronischen Schalter, z. B. einem Transistor, einem Thyristor oder einem Triac, und mit einer Betriebsspannungsversorgungsschaltung für die Zurverfügungstellung der vom Anwesenheitsindikator und ggf. vom Schaltverstärker benötigten internen Betriebsspannung, wobei die Betriebsspannungsversorgungsschaltung einen Längsregler aufweist und der Anwesenheitsindikator und ggf. der Schaltverstärker an den Ausgang des Längsreglers angeschlossen ist bzw. sind.

Elektronische Schaltgerät der zuvor beschriebenen Art sind kontaktlos ausgeführt und werden seit mehr als zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelschaltungen. Das gilt insbesondere für Näherungsschalter, d. h. für elektronische Schaltgeräte, die berührungslos arbeiten. Mit solchen Schaltgeräten wird indiziert, ob sich ein Beeinflussungselement, für das der entsprechende Näherungsschalter sensitiv ist, dem Näherungsschalter hinreichend weit genähert hat. Hat sich nämlich ein Beeinflussungselement, für das der entsprechende Näherungsschalter sensitiv ist, dem Näherungsschalter hinreichend weit genähert, so steuert der Anwesenheitsindikator den elektronischen Schalter um; bei einem als Schließer ausgeführten Schaltgerät wird der zunächst nichtleitend gewesene elektronische Schalter leitend, während bei einem als Öffner ausgeführten Schaltgerät der zunächst leitend gewesene elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten der in Rede stehenden Art ist also u. a. der von außen beeinflußbare Anwesenheitsindikator. Bei induktiven bzw. bei kapazitiven Näherungsschaltern ist als Anwesenheitsindikator in der Regel ein induktiv beeinflußbarer Oszillator bzw. ein kapazitiv beeinflußbarer Oszillator vorgesehen. Optoelektronische Näherungsschalter weisen als Anwesenheitsindikator einen Fotowiderstand, eine Fotodiode oder einen Fototransistor auf (vgl. z. B. die deutschen Offenlegungsschriften 28 24 582, 30 38 102, 33 27 328, 35 14 643, 35 18 025 und 36 05 885). Im übrigen gehören zu den elektronischen Schaltgeräten, mit denen sich die Lehre der Erfindung befaßt, z. B. auch sogenannte Strömungswächter, die eine Temperaturmeßschaltung aufweisen (vgl. z. B. die deutschen Offenlegungsschriften 37 13 891, 38 11 728, 38 25 059, 39 11 008 und 39 43 437).

Bei induktiven Näherungsschaltern gilt für den Oszillator, so lange ein Metallteil einen vorgegebenen Abstand noch nicht erreicht hat, K x V = 1 mit K = Rückkopplungsfaktor und V = Verstärkungsfaktor des Oszillators, d. h. der Oszillator schwingt. Erreicht das entsprechende Metallteil den vorgegebenen Abstand, so führt die zunehmende Bedämpfung des Oszillators zu einer Verringerung des Verstärkungsfaktors V, d. h. die Amplitude der Oszillatorschwingung geht zurück bzw. der Oszillator hört auf zu schwingen. Bei kapazitiven Näherungsschaltern gilt für den Oszillator, so lange ein Ansprechkörper die Kapazität zwischen einer Ansprechelektrode und einer Gegenelektrode noch nicht erreicht hat, K x V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K x V = 1 wird, d. h. der Oszillator beginnt zu schwingen. Bei beiden Ausführungsformen - induktiver Näherungsschalter und kapazitiver Näherungsschalter - wird abhängig von den unterschiedlichen Zuständen des Oszillators der elektronische Schalter, in der Regel über einen Schaltverstärker, gesteuert.

Optoelektronische Näherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Bei elektronischen Schaltgeräten, die über einen Außenleiter mit einem Pol einer Spannungsquelle und nur über einen weiteren Außenleiter mit einem Anschluß eines Verbrauchers verbindbar sind, ist die Zurverfügungstellung der vom Anwesenheitsindikator und ggf. vom Schaltverstärker benötigten Betriebsspannung (= interne Betriebsspannung) bzw. des benötigten Betriebsstroms nicht unproblematisch, weil ja sowohl im leitenden Zustand als auch im gesperrten Zustand des Schaltgeräts die interne Betriebsspannung bzw. der Betriebsstrom zur Verfügung gestellt werden muß.

Es ist belanglos, ob man von der Zurverfügungstellung einer internen Betriebsspannung oder eines Betriebsstroms spricht, weil der Anwesenheitsindikator und ggf. der Schaltverstärker selbstverständlich elektrische Leistung benötigen, also sowohl eine interne Betriebsspannung als auch ein Betriebsstrom benötigt werden (vgl. die ausführliche Darstellung dieses Sachverhaltes in der deutschen Auslegeschrift 23 30 233, insbesondere Spalte 5, Zeile 68, bis Spalte 6, Zeile 33).

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Schaltgeräten der in Rede stehenden Art, also bei Zweileiter-Schaltgeräten, im leitenden Zustand kein Spannungsabfall aufträte, auch keine interne Betriebsspannung für den Anwesenheitsindikator und ggf. den Schaltverstärker gewonnen werden könnte, und dann, wenn im gesperrten Zustand kein Reststrom flösse, auch kein Betriebsstrom gewonnen werden könnte, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig bei elektronischen Schaltgeräten der hier in Rede stehenden Art im leitenden Zustand ein Spannungsabfall auftritt und im gesperrten Zustand ein Reststrom fließt, der Spannungsabfall und der Reststrom so gering wie möglich sein sollen.

Der Problemkreis "Reduzierung des Spannungsabfalls im leitenden Zustand des Schaltgeräts" ist zunächst bereits in einem Teil der schon genannten Druckschriften behandelt, nämlich in den deutschen Offenlegungsschriften bzw. Auslegeschriften bzw. Patentschriften 19 51 137, 21 27 956, 26 13 423 und 27 11 877.

Bei elektronischen Schaltgeräten der hier in Rede stehenden Art ist auch bereits erkannt worden, daß sich der Spannungsabfall im leitenden Zustand des Schaltgeräts weiter reduzieren läßt, wenn man die Betriebsspannungsversorgungsschaltung (für die Zurverfügungstellung der vom Anwesenheitsindikator und ggf. vom Schaltverstärker benötigten Betriebsspannung = interne Betriebsspannung) mit einem DC/DC-Wandler versieht, - weil mit einem solchen DC/DC-Wandler im Sekundärkreis eine höhere Wandlerspannung als im Primärkreis gewonnen werden kann, folglich der Spannungsabfall im leitenden Zustand des Schaltgeräts geringer sein kann als die benötigte interne Betriebsspannung (vgl. die deutschen Offenlegungsschriften 28 08 156, 29 22 309 und 33 20 975).

Im übrigen sind elektronische Schaltgeräte der hier in Rede stehenden Art bekannt, bei denen der steuerbare elektronische Schalter eine relativ hohe Steuerspannung benötigt. Das gilt insbesondere dann, wenn als elektronischer Schalter ein MOS-FET-Leistungstransistor vorgesehen ist (vgl. die deutschen Patentschriften 31 46 709, 33 20 975 und 33 21 838); in diesem Fall wird, abhängig vom über den MOS-FET-Leistungstransistor fließenden Laststrom, eine Gatespannung von etwa 4 - 6 V benötigt.

Insbesondere bei elektronischen Schaltgeräten der in Rede stehenden Art, also bei Zweileiter-Schaltgeräten, die für eine relativ hohe externe Betriebsspannung bestimmt oder jedenfalls geeignet sind, z. B. für eine externe Betriebsspannung von 230 V, also der heute üblichen Netzspannung, sind die Anforderungen an die zu verwendenden Bauelemente zu beachten, die resultieren
a) aus der am Bauelement auftretenden Spannung,
b) aus dem durch das Bauelement fließenden Strom und
c) aus der im Bauelement umgesetzten Leistung.

Im folgenden sollen solche Bauelemente, an denen die externe Betriebsspannung auftreten darf, als spannungsfeste Bauelemente, solche Bauelemente, über die der externe Betriebsstrom fließen darf, als stromfeste Bauelemente und solche Bauelemente, in denen eine erhebliche Leistung umgesetzt werden darf, als Leistungsbauelemente bezeichnet werden.

Von der externen Betriebsspannung, die z. B. 230 V betragen kann, ist die interne Betriebsspannung bzw. der Spannungsabfall am Schaltgerät zu unterscheiden; der Spannungsabfall am Schaltgerät ist idealerweise gleich der internen Betriebsspannung, tatsächlich natürlich stets etwas größer als die interne Betriebsspannung. Zu unterscheiden ist auch der externe Betriebsstrom, d. h. der im leitenden Zustand des Schaltgeräts über das Schaltgerät fließende Strom, von dem internen Betriebsstrom bzw. dem Reststrom, der im gesperrtem Zustand des Schaltgerätes über dieses fließt.

Die Leistung, die in einzelnen Bauelementen umgesetzt wird, kann resultieren
a) aus der externen Betriebsspannung und dem internen Betriebsstrom bzw. dem Reststrom über das Schaltgerät oder
b) aus der internen Betriebsspannung bzw. dem Spannungsabfall am Schaltgerät und dem externen Betriebsstrom.

Bauelemente, in denen Leistungen nach a) oder b) umgesetzt werden dürfen, sind Leistungsbauelemente.

Die im Stand der Technik bekannten Zweileiter-Schaltgeräte für relativ hohe externe Betriebsspannungen sind nun insoweit relativ aufwendig, als bei diesen Schaltgeräten jeweils mindestens zwei Leistungsbauelemente benötigt werden:

Bei einem aus der deutschen Patentschrift 32 38 396 bekannten Schaltgerät ist der zur Betriebsspannungsversorgungsschaltung gehörende Längsregler als Stromregler, nämlich als sogenannter Konstantstromgenerator ausgerührt; der zu dem Längsregler gehörende Transistor, als Generatortransistor bezeichnet, ist ein spannungsfestes Leistungsbauelement. Außerdem gehört zur Betriebsspannungsversorgungsschaltung eine Zenerdiode; hier handelt es sich um ein stromfestes Leistungsbauelement.

Aus der deutschen Patentschrift 33 21 838 ist ein elektronisches Schaltgerät bekannt, zu dessen Betriebsspannungsversorgungsschaltung ein Leistungs-MOS-FET und eine Zenerdiode gehören. Bei dem Leistungs-MOS-FET handelt es sich um ein spannungsfestes Leistungsbauelement, bei der Zenerdiode um ein stromfestes Leistungsbauelement.

Der Erfindung liegt nun die Aufgabe zugrunde, ein elektronisches Schaltgerät der eingangs beschriebenen Art, also ein Zweileiter-Schaltgerät, für relativ hohe externe Betriebsspannungen anzugeben, daß hinsichtlich der verwendbaren Bauelemente weniger aufwendig ist als die bekannten Schaltgeräte.

Das erfindungsgemäße elektronische Schaltgerät, bei dem die zuvor hergeleitete und dargelegte Aufgabe gelöst ist, ist nun zunächst und im wesentlichen dadurch gekennzeichnet, daß die Betriebsspannungsversorgungsschaltung - zusätzlich zu dem Längsregler - einen zweiten Längsregler aufweist, der Eingang des zweiten Längsreglers an den Ausgang des Längsreglers angeschlossen ist, das Stellglied des zweiten Längsreglers mit dem elektronischen Schalter in Reihe liegt, der Anwesenheitsindikator und ggf. der Schaltverstärker auch an die Verbindung des Stellgliedes des zweiten Längsreglers mit dem elektronischen Schalter angeschlossen ist bzw. sind, der elektronische Schalter ein stromfestes Bauelement ist, der Längsregler ein spannungsfestes Bauelement ist und der zweite Längsregler ein spannungs- und stromfestes Leistungsbauelement ist. Das soll nun erläutert werden:

Der bei den im Stand der Technik bekannten elektronischen Schaltgeräten und auch bei dem erfindungsgemäßen Schaltgerät als Teil der Betriebsspannungsversorgungsschaltung vorgesehene Längsregler hat normalerweise die Aufgabe, den Anwesenheitsindikator und ggf. den Schaltverstärker mit der notwendigen elektrischen Leistung zu versorgen. Folglich kann der Längsregler ein Spannungsregler oder ein Stromregler sein. Ist der Längsregler ein Spannungsregler, so sorgt dieser dafür, daß am Anwesenheitsindikator und ggf. am Schaltverstärker nur die notwendige interne Betriebsspannung ansteht; die Differenz zwischen der externen Betriebsspannung (bei gesperrtem Schaltgerät) bzw. dem Spannungsabfall am Schaltgerät (bei leitendem Schaltgerät) einerseits und der internen Betriebsspannung andererseits fällt am Längsregler ab. Ist der Längsregler ein Stromregler, so sorgt dieser dafür, daß ein mehr oder weniger konstanter interner Betriebsstrom fließt, unabhängig von der Größe der externen Betriebsspannung.

Häufig sind elektronische Schaltgeräte so aufgebaut, daß bei den unterschiedlichen Zuständen - Schaltgerät gesperrt oder Schaltgerät leitend - die interne Betriebsspannung bzw. der interne Betriebsstrom unterschiedlich gewonnen wird, nämlich bei gesperrtem Schaltgerät über den Längsregler, bei leitendem Schaltgerät dagegen aus dem über das Schaltgerät fließenden externen Betriebsstrom, also aus dem Laststrom. Es gibt jedoch im Stand der Technik auch Schaltgeräte, bei denen die interne Betriebsspannung bzw. der interne Betriebsstrom in beiden Zuständen des Schaltgerätes mit Hilfe des Längsreglers gewonnen wird.

Zuvor ist bereits ausgerührt worden, daß im leitenden Zustand des Schaltgerätes der Spannungsabfall am Schaltgerät idealerweise gleich der internen Betriebsspannung ist, tatsächlich aber stets etwas größer als die interne Betriebsspannung ist. Jedenfalls ist die Differenz zwischen dem Spannungsabfall am Schaltgerät und der internen Betriebsspannung gering, so daß der Längsregler praktisch "durchgeschaltet" ist. (Das gilt natürlich nur bei solchen Schaltgeräten, bei denen auch im leitenden Zustand die interne Betriebsspannung und der interne Betriebsstrom über den Längsregler zur Verfügung gestellt werden.)

Zu der Betriebsspannungsversorgungsschaltung des erfindungsgemäßen Schaltgerätes gehört nun - zusätzlich zu dem zuvor erläuterten Längsregler - ein zweiter Längsregler. Zweiter Längsregler meint dabei eine Schaltung, die mit Hilfe ihres in Reihe zu dem elektronischen Schalter liegenden Stellgliedes dafür sorgt, daß im gesperrtem Zustand des Schaltgerätes - in Verbindung mit dem Längsregler - die benötigte interne Betriebsspannung zur Verfügung steht und zumindest der größte Teil des internen Betriebsstromes über das Stellglied in den Anwesenheitsindikator und ggf. den Schaltverstärker fließt.

Für das erfindungsgemäße Schaltgerät gilt nun, daß im gesperrten Zustand der Längsregler gleichsam atypisch arbeitet, nämlich nur ein geringer Teil des Betriebsstromes über den Längsregler fließt; der größte Teil des Betriebsstromes fließt ja über das Stellglied des zweiten Längsreglers. Im Gegensatz dazu fließt im leitenden Zustand des Schaltgerätes der interne Betriebsstrom - als geringer Teil des externen Betriebsstromes, also des Laststromes - über den Längsregler. Dem trägt die Erfindung Rechnung, indem für die zu verwendenden Bauelemente erfindungsgemäß vorgesehen ist, daß
a) der elektronische Schalter ein stromfestes Bauelement ist, das jedoch nicht spannungsfest und kein Leistungsbauelement sein muß,
b) der Längsregler (bzw. ein dazu gehörendes elektronisches Bauelement) ein spannungsfestes Bauelement ist, das jedoch nicht stromfest und kein Leistungsbauelement sein muß und
c) der zweite Längsregler (bzw. das dazu als Stellglied gehörende elektronisches Bauelement) ein spannungs- und stromfestes Leistungsbauelement ist.

Es wird nur ein Leistungsbauelement benötigt.

Daß für den elektronischen Schalter kein Leistungsbauelement benötigt wird, ergibt sich daraus, daß zwar über den elektronischen Schalter im leitenden Zustand des Schaltgerätes der größte Teil des Laststromes fließt, der auftretende Spannungsabfall jedoch minimal ist, so daß - als Produkt aus Strom und Spannung - im elektronischen Schalter keine erhebliche Leistung umgesetzt wird.

Für den Längsregler bzw. für das dazu gehörende elektronische Bauelement gilt folgendes: Im gesperrten Zustand des Schaltgerätes steht zwar die externe Betriebsspannung an, es fließt jedoch nur ein sehr geringer Strom, nämlich nur ein geringer Teil des internen Betriebsstromes, also des Reststromes, über den Längsregler. Im leitenden Zustand des Schaltgerätes fließt zwar der gesamte interne Betriebsstrom - als Teil des Laststromes - über den Längsregler, jedoch ist die am Längsregler anstehende Spannung gering. In beiden Fällen ist also die im Längsregler bzw. im dazu gehörenden elektronischen Bauelement umgesetzte Leistung gering.

Für den zweiten Längsregler bzw. für das dazu als Stellglied gehörende elektronische Bauelement gilt folgendes: Im gesperrten Zustand des Schaltgerätes liegt die externe Betriebsspannung an und es fließt der größte Teil des internen Betriebsstromes, also des Reststromes, über das Stellglied des zweiten Längsreglers. Es wird also erhebliche Leistung umgesetzt, so daß ein Leistungsbauelement benötigt wird. Im leitenden Zustand des Schaltgerätes steht zwar nur der Spannungsabfall des Schaltgerätes an, es fließt jedoch der größte Teil des externen Betriebsstromes, also des Laststromes, über das hier in Rede stehende Bauelement. Es wird also auch in diesem Zustand erhebliche Leistung umgesetzt.

Weiter oben ist ausgeführt, daß dann ein Leistungsbauelement benötigt wird, wenn
a) die externe Betriebsspannung ansteht und der interne Betriebsstrom bzw. der Reststrom fließt oder
b) zwar nur die interne Betriebsspannung bzw. der Spannungsabfall des Schaltgerätes ansteht, aber der externe Betriebsstrom, also der Laststrom, zumindest der größte Teil davon, über das Bauelement fließt.

Im Stand der Technik werden ein erstes Leistungsbauelement für den Fall a) und ein zweites Leistungsbauelement für den Fall b) benötigt. Demgegenüber besteht also der "Witz" der Erfindung darin, daß für den Fall a) und für den Fall b) das gleiche Leistungsbauelement zur Verfügung steht, also nur ein Leistungsbauelement benötigt wird.

Im einzelnen gibt es nun verschiedene Möglichkeiten, das erfindungsgemäße elektronische Schaltgerät auszugestalten und weiterzubilden; das gilt insbesondere bezüglich der Realisierung des Längsreglers, des zweiten Längsreglers und des Stellgliedes des zweiten Längsreglers, vor allem aber auch bezüglich der konkreten Realisierung der Maßnahmen, die dazu führen, daß, wie zuvor ausgeführt, bei dem erfindungsgemäßen Schaltgerät einerseits im gesperrten Zustand nur ein geringer Teil des Betriebsstromes über den Längsregler fließt, der größte Teil des Betriebsstromes also über das Stellglied des zweiten Längsreglers fließt, andererseits im leitenden Zustand der interne Betriebsstrom - als geringer Teil des externen Betriebsstromes, also des Laststromes - über den Längsregler fließt. Solche Ausgestaltungen und Weiterbildungen ergeben sich aus den dem Patentanspruch 1 nachgeordneten Patentansprüchen, aus der folgenden Beschreibung von Ausführungsbeispielen und aus den Schaltbildern der erläuterten Ausführungsbeispiele. Es zeigen
- Fig. 1: schematisch, teilweise nur als Blockschaltbild, ein erstes Ausführungsbeispiel eines erfindungsgemäßen elektronischen Schaltgeräts,
- Fig. 2: ein zweites Ausführungsbeispiel eines erfindungsgemäßen elektronischen Schaltgeräts, teilweise nur als Blockschaltbild,
- Fig. 3: ein drittes Ausführungsbeispiel eines erfindungsgemäßen elektronischen Schaltgeräts, wiederum teilweise nur als Blockschaltbild, und
- Fig. 4: ein viertes Ausführungsbeispiel eines erfindungsgemäßen elektronischen Schaltgerätes, ein weiteres Mal teilweise nur als Blockschaltbild.

Die in den Figuren - nur teilweise und teilweise nur schematisch - dargestellten Schaltgeräte arbeiten berührungslos; insbesondere kann es sich um induktive, kapazitive oder optoelektronische Näherungsschalter oder um Strömungswächter handeln. Sie sind über einen nicht dargestellten Außenleiter mit einem Pol einer nicht dargestellten Spannungsquelle und nur über einen weiteren nicht dargestellten Außenleiter mit einem Anschluß eines nicht dargestellten Verbrauchers verbindbar, wobei der andere Anschluß des Verbrauchers an den anderen Pol der Spannungsquelle anschließbar ist; es handelt sich also um Zweileiter-Schaltgeräte.

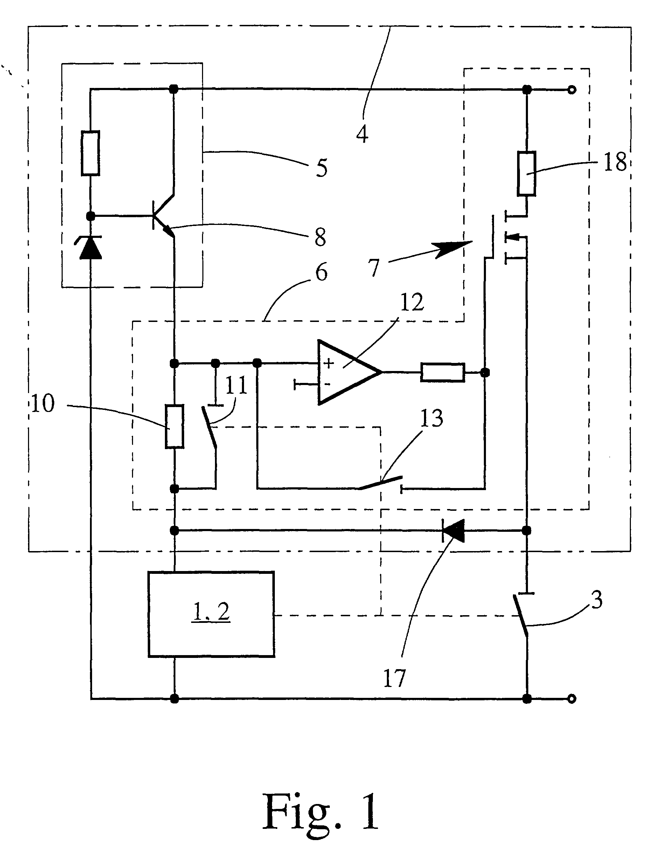

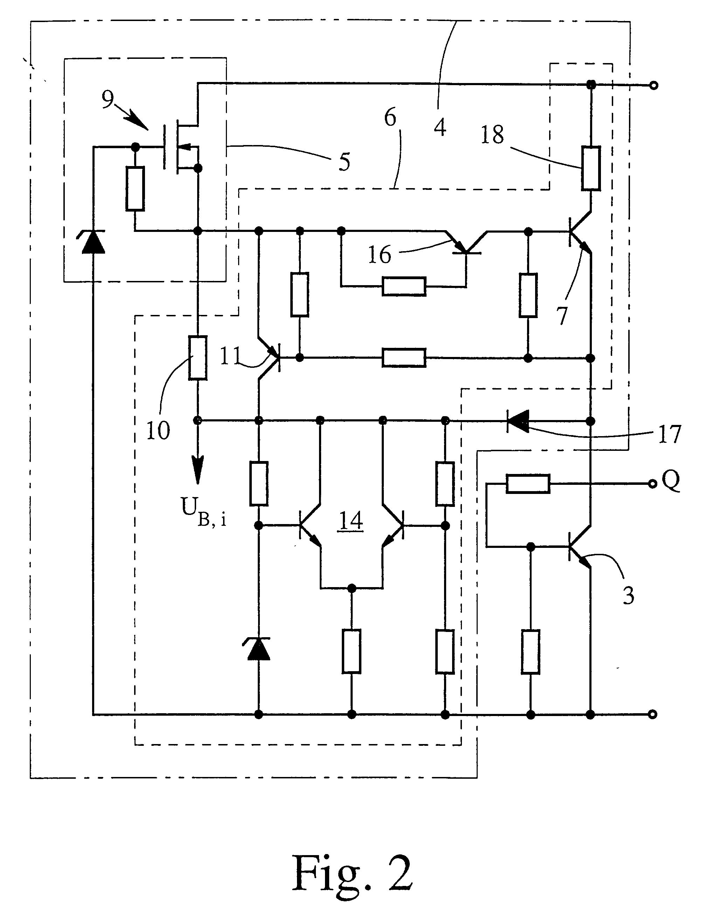

Zu den dargestellten Schaltgeräten gehört nur ein in der Fig. 1 angedeuteter, von aussen beeinflußbarer Anwesenheitsindikator 1, z. B. ein Oszillator, ein nur in Fig. 1 angedeuteter Schaltverstärker 2 und ein von dem Anwesenheitsindikator 1 über den Schaltverstärker 2 steuerbarer elektronischer Schalter 3. Der elektronische Schalter 3 ist im Ausführungsbeispiel nach Fig. 1 nur funktionell dargestellt; in den Ausführungsbeispielen nach den Fig. 2, 3 und 4 ist als elektronischer Schalter 3 jeweils ein npn-Transistor vorgesehen.

Zu den in Rede stehenden elektronischen Schaltgeräten gehört dann ferner eine Betriebsspannungsversorgungsschaltung 4 für die Zurverfügungstellung der vom Anwesenheitsindikator 1 und vom Schaltverstärker 2 benötigten Betriebsspannung (= interne Betriebsspannung). Die Betriebsspannungsversorgungsschaltung 4 weist einen Längsregler 5 auf. Der Anwesenheitsindikator 1 und der Schaltverstärker 2 sind an den Ausgang des Längsreglers 5 angeschlossen.

Wie die Figuren zeigen, weist die Betriebsspannungsversorgungsschaltung 4 - zusätzlich zu dem Längsregler 5 - einen zweiten Längsregler 6 auf. Der Eingang des zweiten Längsreglers 6 ist an den Ausgang des Längsreglers 5 angeschlossen. Zu dem zweiten Längsregler 6 gehört ein Stellglied 7, das mit dem elektronischen Schalter 3 in Reihe liegt. Der Anwesenheitsindikator 1 und der Schaltverstärker 2 sind einerseits, wie bereits ausgeführt, an den Ausgang des Längsreglers 5 angeschlossen, andererseits auch an die Verbindung des Stellgliedes 7 des zweiten Längsreglers 6 mit dem elektronischen Schalter 3 angeschlossen. Mit "angeschlossen" ist gemeint, daß über dieses "Angeschlossensein" der Anwesenheitsindikator 1 und der Schaltverstärker 2 die interne Betriebsspannung und den internen Betriebsstrom bekommen.

Zu der Betriebsspannungsversorgungsschaltung 4 gehört - neben dem Längsregler 5 - der zweite Längsregler 6. Zweite Längsregler 6 meint dabei die Schaltung, die mit Hilfe ihres in Reihe zu dem elektronischen Schalter 3 liegenden Stellgliedes 7 dafür sorgt, daß im gesperrten Zustand des Schaltgerätes - in Verbindung mit dem Längsregler 5 - die benötigte interne Betriebsspannung zur Verfügung steht und zumindest der größte Teil des internen Betriebsstromes über das Stellglied 7 in den Anwesenheitsindikator 1 und den Schaltverstärker 2 fließt. Für die erfindungsgemäßen Schaltgeräte gilt also, daß im gesperrten Zustand des Schaltgerätes der Längsregler 5 gleichsam atypisch arbeitet, nämlich nur ein geringer Teil des Betriebsstromes über den Längsregler 5 fließt; der größte Teil des Betriebsstromes fließt über das Stellglied 7 des zweiten Längsreglers 6. Im Gegensatz dazu fließt im leitenden Zustand des Schaltgerätes der interne Betriebsstrom - als geringer Teil des externen Betriebsstromes, also des Laststromes - über den Längsregler 5.

Im Ausführungsbeispiel nach Fig. 1 weist der Längsregler 5 einen Bipolartransistor auf, nämlich einen npn-Transistor 8. Im Gegensatz dazu weist der Längsregler 5 in den Ausführungsbeispielen nach den Fig. 2, 3 und 4 einen Feldeffekttransistor auf, nämlich einen n-Kanal-Depletion-MOS-FET 9. In allen Ausführungsbeispielen ist zwischen dem Längsregler 5 einerseits sowie dem Anwesenheitsindikator 1 und dem Schaltverstärker 2 andererseits ein Strombegrenzungswiderstand 10 vorgesehen. Dem Strombegrenzungswiderstand 10 ist ein von dem Anwesenheitsindikator 1 bzw. vom Schaltverstärker 2 ansteuerbarer elektronischer Überbrückungsschalter 11 parallel geschaltet.

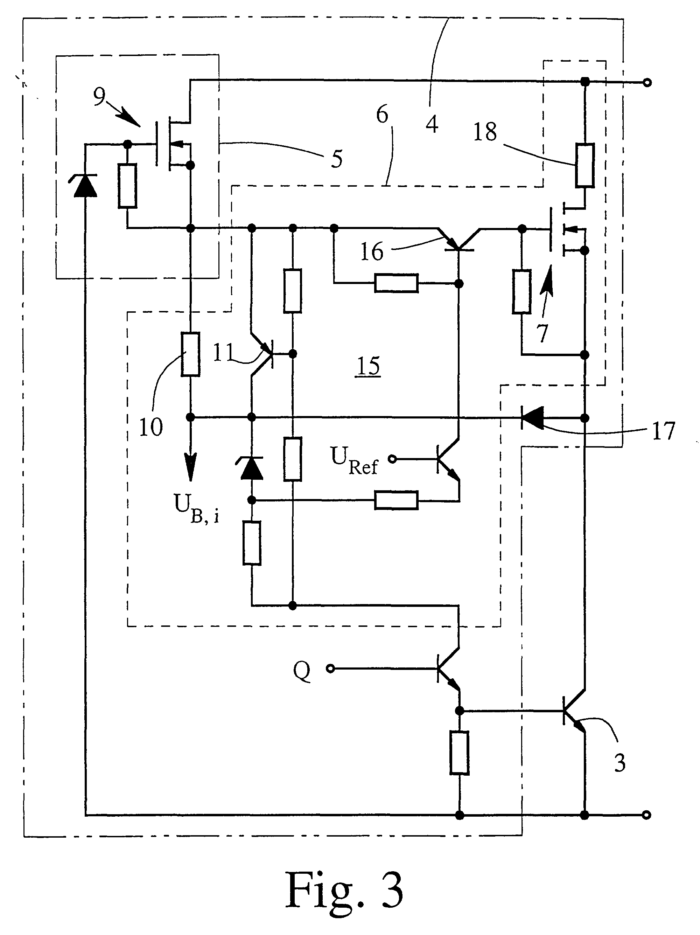

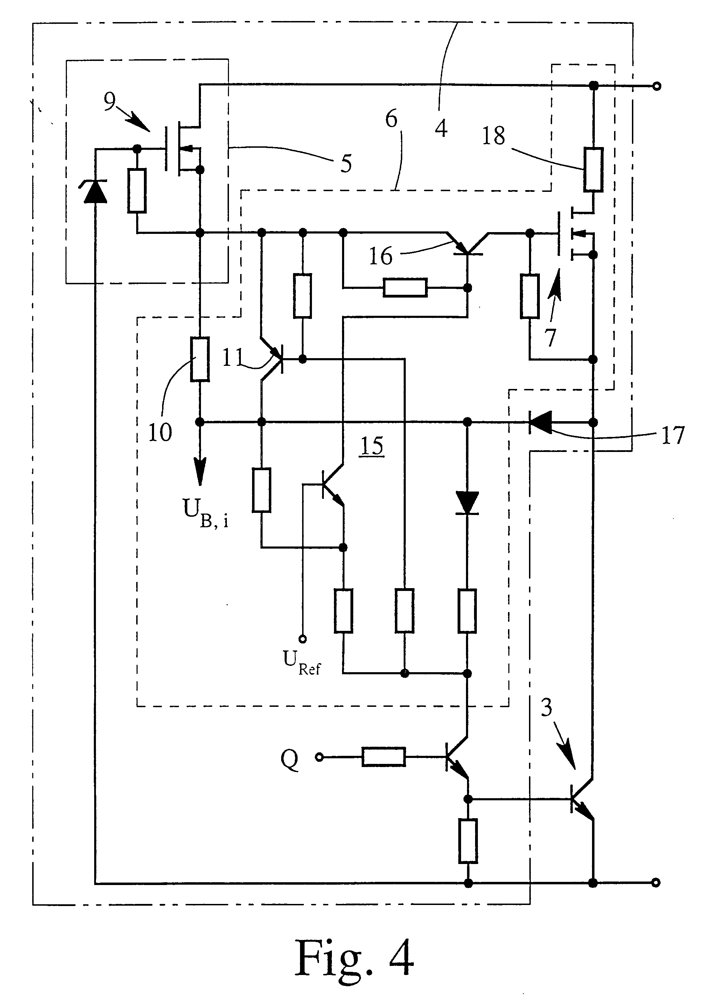

Im Ausführungsbeispiel nach Fig. 1 weist der zweite Längsregler 6 eingangsseitig einen Operationsverstärker 12 auf. Dem Operationsverstärker 12 ist ein vom Anwesenheitsindikator 1 bzw. vom Schaltverstärker 2 ansteuerbarer elektronischer Überbrückkungsschalter 13 parallel geschaltet. Statt des Operationsverstärkers 12 im Ausführungsbeispiel nach Fig. 1 ist im Ausführungsbeispiel nach Fig. 2 ein Differenzverstärker 14 vorgesehen. In den Ausführungsbeispielen nach den Fig. 3, 4 sind normale Verstärker 15 vorgesehen. Bei den Ausführungsbeispielen nach den Fig. 2, 3 und 4 gehört zu dem zweiten Längsregler 6 jeweils ein Steuertransistor 16, der funktionell vergleichbar dem elektronischen Überbrückungsschalter 13 im Ausführungsbeispiel nach Fig. 1 ist.

Hinsichtlich des Stellgliedes 7 des zweiten Längsreglers 6 zeigen die Figuren unterschiedliche Ausführungsbeispiele. In den Ausführungsbeispielen nach den Fig. 1, 3 und 4 ist als Stellglied 7 des zweiten Längsreglers 6 ein Feldeffekttransistor vorgesehen, nämlich ein n-Kanal-Enhancement-MOS-FET. Im Gegensatz dazu ist im Ausführungsbeispiel nach Fig. 2 als Stellglied 7 des zweiten Längsreglers 6 ein npn-Transistor vorgesehen; man könnte den npn-Transistor auch durch eine Darlington-Schaltung aus npn-Transistoren ersetzen.

Im übrigen gilt für alle in den Figuren dargestellten elektronischen Schaltgeräte noch, daß zwischen der Verbindung des Stellgliedes 7 des zweiten Längsreglers 6 und dem elektronischen Schalter 3 einerseits sowie dem Anwesenheitsindikator 1 und dem Schaltverstärker 2 andererseits eine in Durchlaßrichtung geschaltete Steuerdiode 17 vorgesehen ist und daß in Reihe zu dem Stellglied 7 des zweiten Längsreglers 6 ein Entlastungswiderstand 18 liegt.

Weiter oben ist bereits gesagt worden, daß nur in der Fig. 1 angedeutet ist, daß zu dem in Rede stehenden elektronischen Schaltgerät ein von außen beeinflußbarer Anwesenheitsindikator 1 und ein Schaltverstärker 2 gehören. Der Anwesenheitsindikator 1 bzw. der Schaltverstärker 2 steuern den elektronischen Schalter 3 sowie die elektronischen Überbrückungsschalter 11 und 13; das ist in Fig. 1 jeweils nur durch gestrichelte Linien angedeutet. In Fig. 1 ist der elektronische Schalter 3 nur funktionell dargestellt; das gilt auch für die Überbrückungsschalter 11 und 13. In den Fig. 2, 3 und 4 sind der Anwesenheitsindikator und der Schaltverstärker nicht dargestellt. In diesen Figuren ist statt dessen dargestellt, wo die interne Betriebsspannung, mit U_{B, i} bezeichnet, für den Anwesenheitsindikator und den Schaltverstärker zur Verfügung steht. Da in den Fig. 2, 3 und 4 der Anwesenheitsindikator und der Schaltverstärker nicht dargestellt sind, ist in diesen Figuren eingezeichnet, wo das Ausgangssignal des Schaltverstärkers, mit Q bezeichnet, eingespeist wird. Im übrigen ist in den Figuren 2, 3 und 4 dargestellt, daß der elektronische Überbrückungsschalter 11 als pnp-Transistor ausgerührt ist.

Im folgenden soll nun anhand des Ausführungsbeispiels nach Fig. 1 die Funktionsweise des erfindungsgemäßen elektronischen Schaltgeräts erläutert werden:

Zunächst wird davon ausgegangen, daß sich das Schaltgerät im gesperrten Zustand befindet. Dann sind der elektronische Schalter 3 gesperrt, der Überbrückungsschalter 11 gesperrt und der Überbrückungsschalter 13 leitend. Über den Ausgang des Längsreglers 5 und den leitenden Überbrückungsschalter 13 ist das Stellglied 7 des zweiten Längsreglers 6 angesteuert. Der Längsregler 5 arbeitet atypisch. Nur ein geringer Teil des Betriebsstromes für den Anwesenheitsindikator 1 und den Schaltverstärker 2 fließt über den Längsregler 5; das resultiert daraus, daß wegen des gesperrten Überbrückungsschalters 11 der Strombegrenzungswiderstand 10 zwischen dem Ausgang des Längsreglers 5 einerseits sowie dem Anwesenheitsindikator 1 und dem Schaltverstärker 2 andererseits wirksam ist. Der größte Teil des Betriebsstromes fließt über das Stellglied 7 des zweiten Längsreglers 6 und die Steuerdiode 17 zum Anwesenheitsindikator 1 und zum Schaltverstärker 2.

Nun wird davon ausgegangen, daß sich das Schaltgerät im leitenden Zustand befindet. Dann sind der elektronische Schalter 3 leitend, der Überbrückungsschalter 11 leitend und der Überbrückungsschalter 13 gesperrt. Jetzt fließt der gesamte interne Betriebsstrom - als geringer Teil des externen Betriebsstromes, also des Laststromesüber den Längsregler 5 und den leitenden Überbrückungsschalter 11 zum Anwesenheitsindikator 1 und zum Schaltverstärker 2. Vom Stellglied 7 des zweiten Längsreglers 6 kann kein Strom zum Anwesenheitsindikator 1 und zum Schaltverstärker 2 fließen, weil die Steuerdiode 17 nunmehr sperrt; das Potential an der Anode der Steuerdiode 17 ist negativ gegenüber dem Potential an der Kathode der Steuerdiode 17, weil die Anode der Steuerdiode 17 über den leitenden elektronischen Schalter 13 praktisch auf Grundpotential liegt.

Weiter oben ist erläutert worden, daß bei dem erfindungsgemäßen elektronischen Schaltgerät nur ein - spannungs- und stromfestes - Leistungsbauelement benötigt wird, und zwar für das Stellglied 7 des zweiten Längsreglers 6. Ohne weiteres wird also die entstehende Verlustleistung im Stellglied 7 des zweiten Längsreglers 6 umgesetzt. In allen dargestellten Ausführungsbeispielen des erfindungsgemäßen elektronischen Schaltgerätes liegt nun in Reihe zu dem Stellglied 7 des zweiten Längsreglers 6 ein Entlastungswiderstand 18. Das hat die Konsequenz, daß ein Teil der notwendigerweise entstehenden Verlustleistung nun im Entlastungswiderstand 18 umgesetzt wird, das Stellglied 7 des zweiten Längsreglers 6 also nur einen Teil der Verlustleistung übernehmen muß.

Die Ausführungsbeispiele erfindungsgemäßer Schaltgeräte, die in den Fig. 2, 3 und 4 dargestellt sind, bedürfen keiner besonderen weiteren Erläuterung. Wie bereits ausgeführt, unterscheiden sich die Ausführungsbeispiele nach den Fig. 2, 3 und 4 vom Ausführungsbeispiel nach Fig. 1 im wesentlichen durch die konkrete Realisierung des zweiten Längsreglers 6. Während im Ausführungsbeispiel nach Fig. 1 zum zweiten Längsregler 6 der Operationsverstärker 12 und der Überbrückungsschalter 13 gehören, ist im Ausführungsbeispiel nach Fig. 2 ein Differenzverstärker 14, in den Ausführungsbeispielen nach den Fig. 3 und 4 ein normaler Verstärker 15 vorgesehen. Dem Überbrückungsschalter 13 im Ausführungsbeispiel nach Fig. 1 entspricht der Steuertransistor 16 in den Ausführungsbeispielen nach den Fig. 2, 3 und 4. Im übrigen erschließt sich die Funktionsweise des zweiten Längsreglers 6 in den Ausführungsbeispielen nach den Fig. 2, 3 und 4 dem Fachmann ohne weiteres aus den dargestellten konkreten Schaltungen. Zur Lehre der Erfindung gehören auch die in den Fig. 2, 3 und 4 dargestellten konkreten Schaltungen der zweiten Längsregler, d. h. die konkret verwendeten Bauelemente und die sich aus den Fig. 2, 3 und 4 ergebenden Verbindungen der verwendeten Bauelement miteinander.

## Patentansprüche

1. Elektronisches, vorzugsweise berührungslos arbeitendes Schaltgerät, insbesondere induktiver, kapazitiver oder optoelektronischer Näherungsschalter oder Strömungswächter, das über einen Außenleiter mit einem Pol einer Spannungsquelle und nur über einen weiteren Außenleiter mit einem Anschluß eines Verbrauchers verbindbar ist, wobei der andere Anschluß des Verbrauchers an den anderen Pol der Spannungsquelle anschließbar ist, mit einem von außen beeinflußbaren Anwesenheitsindikator (1), z. B. einem Oszillator, mit einem von dem Anwesenheitsindikator (1) - ggf. über einen Schaltverstärker (2) - steuerbaren elektronischen Schalter (3), z. B. einem Transistor, einem Thyristor oder einem Triac, und mit einer Betriebsspannungsversorgungsschaltung (4) für die Zurverfügungstellung der vom Anwesenheitsindikator (1) und ggf. vom Schaltverstärker (2) benötigten internen Betriebsspannung, wobei die Betriebsspannungsversorgungsschaltung (4) einen Längsregler (5) aufweist und der Anwesenheitsindikator (1) und ggf. der Schaltverstärker (2) an den Ausgang des Längsreglers (5) angeschlossen ist bzw. sind, **dadurch gekennzeichnet, daß** die Betriebsspannungsversorgungsschaltung (4) - zusätzlich zu dem Längsregler (5) - einen zweiten Längsregler (6) aufweist, der Eingang des zweiten Längsreglers (6) an den Ausgang des Längsreglers (5) angeschlossen ist, das Stellglied (7) des zweiten Längsreglers (6) mit dem elektronischen Schalter (3) in Reihe liegt, der Anwesenheitsindikator (1) und ggf. der Schaltverstärker (2) auch an die Verbindung des Stellgliedes (7) des zweiten Längsreglers (6) mit dem elektronischen Schalter (3) angeschlossen ist bzw. sind, der elektronische Schalter (3) ein stromfestes Bauelement ist, der Längsregler (5) ein spannungsfestes Bauelement ist und der zweite Längsregler (6) ein spannungs- und stromfestes Leistungsbauelement ist.

2. Elektronisches Schaltgerät nach Anspruch 1, **dadurch gekennzeichnet, daß** der Längsregler (5) einen Bipolartransistor, vorzugsweise einen npn-Transistor (8), oder einen Feldeffekttransistor, vorzugsweise ein n-Kanal-Depletion-MOS-FET (9) aufweist.

3. Elektronisches Schaltgerät nach Anspruch 1 oder 2, **dadurch gekennzeichnet, daß** zwischen dem Längsregler (5) einerseits sowie dem Anwesenheitsindikator (1) und ggf. dem Schaltverstärker (2) andererseits ein Strombegrenzungswiderstand (10) vorgesehen ist.

4. Elektronisches Schaltgerät nach Anspruch 3, **dadurch gekennzeichnet, daß** dem Strombegrenzungswiderstand (10) ein vom Anwesenheitsindikator (1) bzw. vom Schaltverstärker (2) ansteuerbarer elektronischer Überbrückungsschalter (11) parallel geschaltet ist.

5. Elektronisches Schaltgerät nach einem der Ansprüche 1 bis 4, **dadurch gekennzeichnet, daß** der zweite Längsregler (6) einen Operationsverstärker (12) oder einen Differenzverstärker (14) aufweist.

6. Elektronisches Schaltgerät nach Anspruch 5, **dadurch gekennzeichnet, daß** dem Operationsverstärker (12) ein vom Anwesenheitsindikator (1) bzw. vom Schaltverstärker (2) ansteuerbarer elektronischer Überbrückungsschalter (13) parallel geschaltet ist.

7. Elektronisches Schaltgerät nach einem der Ansprüche 1 bis 5, **dadurch gekennzeichnet, daß** der zweite Längsregler (6) einen Steuertransistor (16) aufweist.

8. Elektronisches Schaltgerät nach einem der Ansprüche 1 bis 7, **dadurch gekennzeichnet, daß** als Stellglied (7) des zweiten Längsreglers (6) ein Feldeffekttransistor, vorzugsweise ein n-Kanal-Enhancement-MOS-FET, oder ein Bipolartransistor, vorzugsweise npn-Transistor oder eine Darlington-Schaltung aus npn-Transistoren, vorgesehen ist.

9. Elektronisches Schaltgerät nach einem der Ansprüche 1 bis 8, **dadurch gekennzeichnet, daß** zwischen der Verbindung des Stellgliedes (7) des zweiten Längsreglers (6) und dem elektronischen Schalter (3) einerseits sowie dem Anwesenheitsindikator (1) und ggf. dem Schaltverstärker (2) andererseits eine in Durchlaßrichtung geschaltete Steuerdiode (17) vorgesehen ist.

10. Elektronisches Schaltgerät nach einem der Ansprüche 1 bis 9, **dadurch gekennzeichnet, daß** in Reihe zu dem Stellglied (7) des zweiten Längsreglers (6) ein Entlastungswiderstand (18) liegt.

## Claims

1. Electronic, preferably proximity switching device, especially an inductive, capacitive or opto-electric proximity indicator (1) or a flow monitor which can be connected via an outside conductor to one pole of a voltage source and only via one other outside conductor to a terminal of a consumer, in which the other terminal of the consumer can be connected to the other pole of the voltage source, with a proximity indicator (1) which can be influenced from the outside, for example, an oscillator, with an electronic switch (3), for example, a transistor, thyristor or Triac, which can be controlled by the proximity indicator (1)-optionally via a switching amplifier (2) - and with an operating voltage supply circuit (4) for making available the internal operating voltage required by the proximity indicator (1) and optionally by the switching amplifier (2), the operating voltage supply circuit (4) having an in-phase regulator (5) and the proximity indicator and optionally the switching amplifier (2) being connected to the output of the in-phase regulator (5) **characterized in that** the operating voltage supply circuit (4) - in addition to the in-phase regulator (5) - has a second in-phase regulator (6), the input of the second in-phase regulator (6) is connected to the output of the in-phase regulator (5), the actuator (7) of the second in-phase regulator (6) is in series with the electronic switch (3), and the proximity indicator (1) and, optionally, the switching amplifier (2) is/are also connected to the electronic switch (3) at the connection of the actuator (7) of the second in-phase regulator (6), the electronic switch (3) is a current-steady component, the in-phase regulator (5) is a voltage-steady component and the second in-phase regulator (6) is a current- and voltage-steady high performance component.

2. Electronic switching device according to claim 1, **characterized in that** the in-phase regulator (5) has a bi-polar transistor, preferably a npn-transistor (8) or a field effect transistor, preferably a n-channel depletion MOS-FET (9).

3. Electronic switching device according to claims 1 or 2, **characterized in that** a current limiting resistor (10) is provided between the in-phase regulator (5) on the one hand as well as the proximity indicator (2) and, if applicable the switching amplifier (2) on the other.

4. Electronic switching device according to claim 3, **characterized in that** the current limiting resistor (10) is switched parallel to the electronic bridging switch (11) which is controllable by the proximity indicator (1) or, if applicable, the switching amplifier (2).

5. Electronic switching device according to any one of claims 1 to 4, **characterized in that** the second in-phase regulator (6) has an operating amplifier (12) or an difference amplifier (14).

6. Electronic switching device according to claim 5, **characterized in that** the operating amplifier (12) is switched parallel to the proximity indicator (1) or to the switching amplifier (2).

7. Electronic switching device according to any one of claims 1 to 5, **characterized in that** the second in-phase regulator (6) has a control transistor (16).

8. Electronic switching device according to any one of claims 1 to 7, **characterized in that** a field effective transistor, preferably a n-channel enhancement MOS-FET, or a bi-polar transistor, preferably a npn-transistor or a Darlington-switch of npn-transistors is provided as actuator (7) of the second in-phase regulator (6).

9. Electronic switching device according to any one of claims 1 to 8, **characterized in that** a control diode (17) switched in the conducting direction is provided between the connection of the actuator (7) of the second in-phase regulator (6) and the electronic switch (3) on the one hand as well as the proximity indicator (1) and, if applicable, the switching amplifier (2) on the other hand.

10. Electronic switching device according to any one of claims 1 to 9, **characterized in that** a relief resistor (18) lies in series with the actuator (7) of the second in-phase regulator (6).

## Revendications

1. Appareil de coupure électronique, fonctionnant de préférence sans contact, notamment un détecteur de proximité à inductance, à capacitance ou optoélectronique ou un contrôleur de flux, lequel peut être connecté à un pôle d'une source de tension par l'intermédiaire d'un conducteur extérieur et à une borne d'un consommateur de courant seulement par l'intermédiaire d'un autre conducteur extérieur, l'autre borne du consommateur pouvant être reliée à l'autre pôle de la source de tension, avec un indicateur de présence (1) influençable de l'extérieur, un oscillateur par exemple, avec un actionneur électronique (3), un transistor, un thyristor ou un triac par exemple, réglable par l'indicateur de présence (1), via un amplificateur de communication (2) le cas échéant, et avec un circuit d'approvisionnement en tension de fonctionnement (4) pour la mise à disposition de la tension de fonctionnement interne requise par l'indicateur de présence (1) et le cas échéant, l'amplificateur de communication (2), le circuit d'approvisionnement en tension de fonctionnement (4) présentant un régulateur longitudinal (5) et l'indicateur de présence (1) et le cas échéant, l'amplificateur de commutation (2) sont reliés à la sortie du régulateur longitudinal (5), **caractérisé en ce que** le circuit d'approvisionnement en tension de fonctionnement (4) présente en plus du régulateur longitudinal (5), un second régulateur longitudinal (6) dont l'entrée est reliée à la sortie du premier régulateur longitudinal (5) et dont le composant de réglage (7) est en série avec l'actionneur électronique (3), l'indicateur de présence (1) et le cas échéant, l'amplificateur de commutation (2), sont également reliés à la connexion du composant de réglage (7) du second régulateur longitudinal (6) avec l'actionneur électronique (3), ce dernier (3) est un composant insensible au courant, le régulateur longitudinal (5) est un composant à tension invariable et **en ce que** le second régulateur longitudinal (6) est un composant de puissance à tension invariable et insensible au courant.

2. Appareil de coupure électronique selon la revendication 1 **caractérisé en ce que** le régulateur longitudinal (5) présente un transistor bipolaire, de préférence un transistor N-P-N (8) ou un transistor à effet de champ, de préférence un TECMOS à canal N à mode d'appauvrissement (9).

3. Appareil de coupure électronique selon la revendication 1 ou 2 **caractérisé en ce qu'**une résistance limiteuse de courant (10) est prévue entre le régulateur longitudinal (5) d'une part et l'indicateur de présence (1) et, le cas échéant, l'amplificateur de commutation (2) d'autre part.

4. Appareil de coupure électronique selon la revendication 3 **caractérisé en ce qu'**un court-circuiteur (11) électronique que peuvent exciter l'indicateur de présence (1) et le cas 'échéant, l'amplificateur de commutation (2), est monté en parallèle avec la résistance limiteuse de courant (10).

5. Appareil de coupure électronique selon l'une des revendications 1 à 4 **caractérisé en ce que** le second régulateur longitudinal (6) présente un amplificateur opérationnel (12 ) ou un amplificateur différentiateur (14).

6. Appareil de coupure électronique selon la revendication 5 **caractérisé en ce qu'**un court-circuiteur (13) électronique que peuvent exciter l'indicateur de présence (1) et le cas échéant, l'amplificateur de commutation (2), est monté en parallèle avec l'amplificateur opérationnel (12).

7. Appareil de coupure électronique selon l'une des revendications 1 à 5 **caractérisé en ce que** le second régulateur longitudinal (6) présente un transistor pilote (16).

8. Appareil de coupure électronique selon l'une des revendications 1 à 7 **caractérisé en ce qu'**est prévu comme composant de réglage (7) du second régulateur longitudinal (6) un transistor à effet de champ, de préférence un TECMOS à canal N de type à enrichissement, ou un transistor bipolaire, de préférence un transistor N-P-N ou un montage Darlington comprenant plusieurs transistors N-P-N.

9. Appareil de coupure électronique selon l'une des revendications 1 à 8 **caractérisé en ce qu'**une diode pilotée (17) montée dans le sens du courant est prévue entre la connexion du composant de réglage (7) du second régulateur longitudinal (6) d'une part et l'indicateur de présence (1) et, le cas "échéant, l'amplificateur de commutation (2) d'autre part.

10. Appareil de coupure électronique selon l'une des revendications 1 à 9 **caractérisé en ce qu'**une résistance de décharge (18) est disposée en série par rapport au composant de réglage (7) du second régulateur longitudinal (6).
